# EUROPÄISCHE PATENTSCHRIFT

(11) **EP 4 073 601 B1**
(45) Veröffentlichungstag und Bekanntmachung des Hinweises auf die Patenterteilung: **30.07.2025**
(21) Anmeldenummer: 20824913.6
(22) Anmeldetag: 10.12.2020
(51) Int. Cl.: G05B 19/042

(54) **VERARBEITUNGSVORRICHTUNG ZUM STEUERN, MESSEN UND REGELN**
PROCESSING APPARATUS FOR CONTROLLING, MEASURING AND REGULATING
APPAREIL DE TRAITEMENT DESTINÉ À CONTRÔLER, MESURER ET RÉGULER

(30) Priorität: 10.12.2019 DE 102019133746
(43) Veröffentlichungstag der Anmeldung: 19.10.2022
(73) Patentinhaber: Qlar Europe GmbH, 64293 Darmstadt (DE)
(72) Erfinder: RAUCHSCHWALBE, Ulrich, 64846 Groß-Zimmern Hessen (DE); ALLENBERG, Bernd, 64347 Muehltal Hessen (DE); BOHRMANN, Dino, 68309 Mannheim (DE); DITTRICH, Harald, 65462 Ginsheim-Gustavsburg (DE)
(86) Internationale Anmeldenummer: PCT/EP2020/085471
(87) Internationale Veröffentlichungsnummer: WO 2021/116267

(56) Entgegenhaltungen:
- EP-A1- 3 309 637
- EP-A2- 1 372 366
- DE-U1- 20 307 308

## Beschreibung

Die Erfindung betrifft eine Verarbeitungsvorrichtung zum Steuern, Messen und Regeln mit einem Einbaugerät zur Ausgabe, beispielsweise von Informationen und/oder zur Eingabe, beispielsweise von Steuerbefehlen. Das Einbaugerät zur Ausgabe und/oder Eingabe wird nachfolgend auch als ein Aus- und/oder Eingabegerät bezeichnet.

Verarbeitungsvorrichtungen mit Einbaugeräten, die beispielsweise zur Steuerung, Überwachung, Erfassung und/oder Regelung von Prozessen, Maschinen und/oder Anlagen eingesetzt werden, sind im Allgemeinen aus dem Stand der Technik bekannt.

Die EP 3 309 637 A1 betrifft ein Steuerungssystem zur Steuerung des Betriebs einer numerisch gesteuerten Werkzeugmaschine, wobei das System eine Back-End-Steuerungseinrichtung und eine Front-End-Steuerungseinrichtung umfasst, die mit der Back-End-Steuerungseinrichtung in Verbindung steht.

Die EP 1 372 366 A2 betrifft ein elektronisches Gerät, das mit einer Vielzahl von Substraten ausgestattet ist.

Ein großer Nachteil der bekannten Verarbeitungsvorrichtungen liegt jedoch oft darin, dass entweder eine Vielzahl von Vorrichtungen und/oder Einbaugeräten für mehrere Verwendungen notwendig sind oder dass das jeweilige Einbaugerät für die geplante Verwendung nicht optimal geeignet ist oder aufwändig an die Verwendung angepasst werden muss.

Die Aufgabe der Erfindung wird durch eine Verarbeitungsvorrichtung (für Daten) mit einem Einbaugerät zur Ausgabe und/oder zur Eingabe mit den Merkmalen des Patentanspruchs 1 gelöst. Vorteilhafte Ausführungsformen und Weiterbildungen sind in den Unteransprüchen beansprucht.

Das Einbaugerät oder das Aus - und/oder Eingabegerät dient zur Ausgabe von Informationen aus den Mess-, Steuer- und Regelprozessen der mit dem Einbaugerät verbundenen Anlagen. Dementsprechend dient das Einbaugerät zur Eingabe von Daten, einer Authentifizierung, eines Parameters, einer Auftragsnummer oder zum Auslösen von Prozessen. Das Einbaugerät weist ein Zwischengehäuse auf. Ferner weist das Einbaugerät eine Einheit zum Anzeigen, beispielsweise der Informationen, und/oder zum Bedienen beispielsweise zum Eingeben der Steuerbefehle, auf. Die Einheit zum Anzeigen und/oder Bedienen wird nachfolgend auch als eine Anzeige- und/oder Bedieneinheit bezeichnet. Die Einheit ist vorzugsweise an dem Zwischengehäuse befestigt, d.h. fest angebracht. Die Einheit zum Anzeigen und/oder Bedienen dient als Schnittstelle zu einem Benutzer. Abhängig von der industriellen Umgebung, in der das Einbaugerät verwendet wird, kann die Anzeige- und/oder Bedieneinheit kombiniert als Touchscreen oder als Bildschirm oder Monitor mit separater Tastatur zum Einsatz kommen. Zudem weist das Einbaugerät eine Hauptplatine auf. Die Hauptplatine, die auch als Mainboard oder Modulträger mit Prozessor bezeichnet werden kann, ist vorzugsweise an dem Zwischengehäuse befestigt oder in dem Zwischengehäuse aufgenommen. Die Hauptplatine weist eine zentrale Recheneinheit auf. Insbesondere ist die Recheneinheit mit der Anzeige- und/oder Bedieneinheit elektronisch verbunden. Erfindungsgemäß ist das Einbaugerät zur Verwendung in einer signalgebenden oder signalverarbeitenden Einrichtung oder für eine signalgebende oder signalverarbeitende Einrichtung wahlweiseeiner Wägeeinrichtung, Dosiereinrichtung, Fördereinrichtung, Siebeinrichtung, Mahleinrichtung, Mischeinrichtung, Filtereinrichtung, Zustandsüberwachungseinrichtung und/ oder Materialanalyseeinrichtung, vorgesehen. Die Hauptplatine dient als eine elektronische Plattform unabhängig von der Verwendung, d.h. für jede Einrichtung aus der Gruppe. Das heißt, dass die Hauptplatine des Einbaugeräts für alle Einrichtungen gleich ist. Dies hat den Vorteil, dass zu jedem Zeitpunkt eine weitere Einrichtung an das Einbaugerät angeschlossen und durch das Einbaugerät gesteuert, bedient etc. werden kann, ohne dass Änderungen an der elektronischen Plattform der Hauptplatine notwendig sind. Mit anderen Worten ist das Einbaugerät modular für mehrere und/oder verschiedene Verwendungen einsetzbar. Die Hauptplatine weist wenigstens eine analoge Schnittstelle und/oder wenigstens eine digitale Schnittstelle, beispielsweise zur Datenübertragung, zu der jeweiligen Einrichtung auf. Vorzugsweise weist die Hauptplatine mehrere Schnittstellen, analoge und/oder digitale, auf, so dass mehrere Einrichtungen gleichzeitig oder zeitlich abwechselnd angeschlossen werden können. Dadurch kann jede Schnittstelle auf die jeweilige Einrichtung, die über diejenige Schnittstelle mit der Hauptplatine verbunden wird, angepasst sein. Die Hauptplatine dient daher als eine elektronische Plattform unabhängig von der Verwendung und wiest je Verwendung eine spezifische Kombination von Schnittstellen zu der jeweiligen Einrichtung auf.

Vorzugsweise kann die Schnittstelle zum Anschluss eines USB-WLAN-Sticks, eines USB-Bluetooth-Sticks, eines USB-Funkmoduls und/oder eines USB-Ethernet-Sticks ausgebildet sein. Dadurch können Daten der jeweiligen Einrichtungen über verschiedene, übliche Datenübertragungsstandards an die Hauptplatine übertragen werden. Bevorzugt können die Daten der jeweiligen Einrichtung in der zentralen Recheneinheit der Hauptplatine verarbeitet und über die Anzeige und/oder Bedieneinheit angezeigt werden. Zusätzlich können beispielsweise vom Benutzer über die Bedieneinheit eingegebene Daten und/oder Steuerungsbefehle vorzugsweise in der zentralen Recheneinheit der Hauptplatine verarbeitet und über die Schnittstelle, per Datenübertragung, an die jeweilige Einrichtung gesendet werden. Zusätzlich zu den bereits beschriebenen Schnittstellen, weist die Hauptplatine eine oder mehrerer Aufnahmeschnittstellen zur Aufnahme und Verbindung eines Funktionsmoduls auf.

Das Funktionsmodul kann auch als ein Applikationsmodul bezeichnet werden. Vorzugsweise wird jedes Funktionsmodul durch eine Optionskarte gebildet, die in die Aufnahmeschnittstelle der Hauptplatine einsteckbar ist. Durch das Verbinden des Funktionsmoduls mit der Hauptplatine können unterschiedliche Funktionen realisiert und werden. Das Einbaugerät ist modular mit einem oder mehreren Funktionsmodulen ausgewählt aus einer Vielzahl von Funktionsmodulen ausgestattet. Dadurch kann das Einbaugerät auf besonders einfache Weise kundenspezifisch konfiguriert werden. Durch die Auswahl des jeweiligen Funktionsmoduls wird aus der Verarbeitungsvorrichtung, die als Grundplattform dient, ein spezifisches an einen Prozess angepasstes Steuer-, Mess- und/oder Regelgerät. Dementsprechend umfasst jedes Funktionsmodul wiederum eine oder mehrerer spezifische Schnittstellen zur jeweiligen Einrichtung.

**In** einer bevorzugten Weiterbildung kann/können das Funktionsmodul oder die Funktionsmodule, vorzugsweise über eine Steckverbindung, mit der Aufnahmeschnittstelle zerstörungsfrei verbindbar und von der Aufnahmeschnittstelle zerstörungsfrei lösbar sein. Somit kann der durch die Funktionsmodule, insbesondere die Art und Anzahl der Funktionsmodule, definierte Funktionsumfang des Einbaugeräts und/oder der Verarbeitungsvorrichtung vorteilhafterweise optimal an den Kunden und auch an sich verändernde Bedürfnisse oder Anforderungen angepasst werden.

Erfindungsgemäß wird also eine Verarbeitungsvorrichtung mit einem Aus- und/oder Eingabegerät bereitgestellt, das so ausgebildet ist, dass es modular für Wägeeinrichtungen, Dosiereinrichtungen, Fördereinrichtungen, Siebeinrichtungen, Mahleinrichtungen, Mischeinrichtungen, Filtereinrichtungen, Zustandsüberwachungseinrichtungen und/ oder Materialanalyseeinrichtungen eingesetzt werden kann. Damit können auch mehrere der genannten Einrichtungen über eine gemeinsame Verarbeitungsvorrichtung bzw. ein gemeinsames Aus- und/oder Eingabegerät bedient, gesteuert und/oder überwacht werden.

Die Verarbeitungsvorrichtung zum Steuern, Messen und/oder Regeln wird nachfolgend auch als Controller, Steuergerät, Messgerät und/oder Regelgerät bezeichnet. Wie zuvor erwähnt, umfasst ein Funktionsmodul wiederum Schnittstellen zu der jeweiligen Einrichtung, zu deren Steuerung, Regelung oder Messung die Verarbeitungsvorrichtung eingesetzt ist. Beispielsweise kann ein Funktionsmodul ein Wägezellenmodul für eine diskontinuierliche Waage, u.a. eine Fahrzeugwaage, sein und Schnittstellen zu einer oder mehreren Wägezellen und/oder einem oder mehreren Näherungssensoren umfassen.

Gemäß einer bevorzugten Ausführungsform kann die Anzeige- und/oder Bedieneinheit formschlüssig mit dem Zwischengehäuse zerstörungsfrei verbindbar und zerstörungsfrei von dem Zwischengehäuse lösbar sein. Beispielsweise kann die Anzeige- und/oder Bedieneinheit über eine Clipsverbindung oder eine Verrastung mit dem Zwischengehäuse verbunden sein. Dadurch wird eine einfach montierbare, leicht lösbare sowie sichere Verbindung zwischen den Bestandteilen des Einbaugeräts bereitgestellt. Vorzugsweise ist die Anzeige- und/oder Bedieneinheit so angeordnet, dass sie die Hauptplatine abdeckt. Dadurch wird die Hauptplatine vor der Umgebung und äußeren Einflüssen geschützt, bleibt aber gleichzeitig durch die lösbare Befestigung der Anzeige- und/oder Bedieneinheit an dem Zwischengehäuse leicht zugänglich.

Besonders bevorzugt ist es, wenn das Zwischengehäuse Führungen besitzt, in denen die Funktionsmodule aufgenommen sind. Mit anderen Worten kann/können das Funktionsmodul oder die Funktionsmodule in dafür vorgesehenen Führungen des Zwischengehäuse geführt sein. Beispielsweise können die Führungen als Schienen ausgebildet sein, auf denen die Funktionsmodule aufliegen. Vorzugsweise sind die Funktionsmodule übereinander oder nebeneinander angeordnet. Dadurch kann eine geführte und kompakte Anordnung der Funktionsmodule in dem Zwischengehäuse gewährleistet werden.

Gemäß einer bevorzugten Ausführungsform kann das Einbaugerät eine Rückwand aufweisen, die vorzugsweise formschlüssig, mit dem Zwischengehäuse zerstörungsfrei verbindbar und von dem Zwischengehäuse zerstörungsfrei lösbar ist. Beispielsweise kann die Rückwand über eine Clipsverbindung oder eine Verrastung mit dem Zwischengehäuse verbunden sein. Vorzugsweise ist die Rückwand so ausgebildet, dass sie die Hauptplatine abdeckt.

In einer bevorzugten Weiterbildung kann die Rückwand heraustrennbare, etwa ausbrechbare, Abdeckbleche besitzen. Die Abdeckbleche sind hinsichtlich ihrer Geometrie so ausgebildet, dass sie jeweils eine Schnittstelle (für eine Einrichtung) oder eine Aufnahmeschnittstelle (für ein Funktionsmodul) der Hauptplatine abdecken. Somit kann die Steifigkeit der Rückwand verbessert werden, da die Abdeckbleche nur so groß ausgebildet sind, dass bei ihrem Heraustrennen die jeweilige Schnittstelle oder Aufnahmeschnittstelle zugänglich ist, und nur die Abdeckbleche herausgetrennt werden müssen, die eine Schnittstelle oder Aufnahmeschnittstelle, die verwendet wird, bedecken. Beispielsweise können die Abdeckbleche eine Werkzeugschnittstelle aufweisen, an die ein Werkzeug zum Heraustrennen des jeweiligen Abdeckblechs ansetzbar ist. Die Werkzeugschnittstelle kann als ein Schlitz ausgebildet sein.

Gemäß einer bevorzugten Ausführungsform können/kann das Einbaugerät und/oder die Anzeige- und/oder Bedieneinheit um eine Achse senkrecht zu einer Bildschirmfläche der Anzeige- und/oder Bedieneinheit, vorzugsweise um 180° oder 90°, drehbar ausgebildet sein und/oder um 180° oder 90° gedreht befestigt werden. Dies hat den Vorteil, dass die Bildschirmfläche, beispielsweise je nach Art der Anbringung, für den Benutzer optimal ausgerichtet werden kann.

Ferner ist es vorteilhaft, wenn das Einbaugerät mit einem Außengehäuse der Verarbeitungsvorrichtung und/oder mit einem Halterahmen der Verarbeitungsvorrichtung, vorzugsweise kraftschlüssig, verbindbar ist. Beispielsweise kann das Einbaugerät in dem Außengehäuse aufgenommen sein.

Gemäß einer bevorzugten Weiterbildung kann das Außengehäuse mehrteilig ausgebildet sein. Die Bauteile des Außengehäuses sind, vorzugsweise formschlüssig und voneinander lösbar, miteinander verbindbar.

Zudem ist es zweckmäßig, wenn das Einbaugerät in dem Außengehäuse wahlweise in einer ersten Position und in einer um eine Achse senkrecht zur Bildschirmfläche der Einheit um 180° gedrehten, zweiten Position befestigbar ist. Somit bietet sich dem Benutzer eine große Flexibilität hinsichtlich der Nutzung.

Gemäß der Weiterbildung kann das Außengehäuse, in dem das Einbaugerät aufgenommen ist, vorzugsweise an einer Wand befestigbar oder auf einen Tisch stellbar sein. So kann die Verarbeitungsvorrichtung an die räumlichen Gegebenheiten angepasst montiert werden.

Gemäß einer bevorzugten Weiterbildung kann das Außengehäuse Sicherungsseile, vorzugsweise Nylonseile, zur Befestigung voneinander lösbarer Bauteile des Außengehäuses aneinander besitzen. Dadurch wird beim Öffnen des Außengehäuses, bzw. beim Lösen der Bauteile voneinander, die Gefahr einer Beschädigung, falls ein Bauteil herunterfällt, verringert.

Weiterhin ist es von Vorteil, wenn das Zwischengehäuse in Form eines Tubusgehäuses ausgebildet ist, das wenigstens einen quaderförmigen Innenraum zum Aufnehmen des wenigstens einen Funktionsmoduls oder mehrerer Funktionsmodule und/oder der Schnittstellen aufweist. Somit lassen sich die elektronischen, oftmals hochempfindlichen Bauteile in geeigneter Weise schützen.

Ferner ist es vorteilhaft, wenn die Rückwand der Form des Zwischengehäuses, insbesondere des Tubusgehäuses, angepasst ist und dementsprechend als Massenanschluss aller modularen Funktionsmodule dient.

Die Erfindung wird nachfolgend mit Hilfe von Zeichnungen erläutert. Es zeigen:
- Fig. 1: eine perspektivische Ansicht eines erfindungsgemäßen Einbaugeräts,
- Fig. 2: eine Explosionsdarstellung des Einbaugeräts,
- Fign. 3 und 4: perspektivische Ansichten einer Einheit zum Anzeigen und/oder Bedienen des Einbaugeräts,
- Fign. 5 und 6: perspektivische Ansichten eines Zwischengehäuses des Einbaugeräts,
- Fig. 7: eine perspektivische Ansicht des Einbaugeräts während der Montage,
- Fig. 8: eine Rückansicht einer Hauptplatine des Einbaugeräts,
- Fig. 9: eine perspektivische Ansicht des Einbaugeräts von hinten,
- Fig. 10: eine Rückansicht einer Rückwand des Einbaugeräts,
- Fign. 11 und 12: perspektivische Ansicht des Einbaugeräts während der Montage,
- Fign. 13 und 14: eine erfindungsgemäße Verarbeitungsvorrichtung mit dem Einbaugerät in einer Ausbildung als Tischgerät, und
- Fign. 15 und 16: die Verarbeitungsvorrichtung in einer Ausbildung als Wandgerät.

Die Figuren sind lediglich schematischer Natur und dienen ausschließlich dem Verständnis der Erfindung. Gleiche Elemente sind mit denselben Bezugszeichen gekennzeichnet. Merkmale unterschiedlicher Ausführungsformen können untereinander ausgetauscht werden.

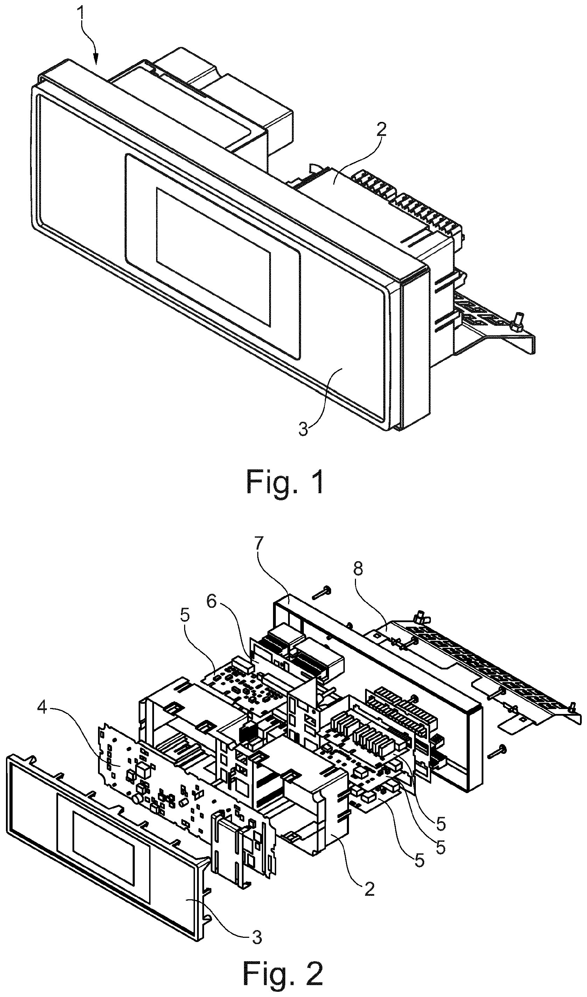

Fig. 1 zeigt ein Einbaugerät 1 für eine erfindungsgemäße Verarbeitungsvorrichtung. Das Einbaugerät 1 wird auch als eine Eingabe- und/oder Ausgabegerät bezeichnet. Das Einbaugerät 1 weist ein Zwischengehäuse 2, eine Einheit 3 zum Anzeigen und/oder Bedienen und eine mit der Einheit 3 verbundene Hauptplatine 4. Die Hauptplatine 4 weist eine zentrale Recheneinheit auf. Erfindungsgemäß ist die Verarbeitungsvorrichtung mit dem Einbaugerät 1 zur Verwendung in einer oder für eine signalgebende oder signalverarbeitende Einrichtung wahlweise einer Wägeeinrichtung, Dosiereinrichtung, Fördereinrichtung, Siebeinrichtung, Mahleinrichtung, Mischeinrichtung, Filtereinrichtung, Zustandsüberwachungseinrichtung und/oder Materialanalyseeinrichtung vorgesehen. Die Hauptplatine 4 dient als eine elektronische Plattform unabhängig von der Verwendung und weist je Verwendung eine eigene Kombination von Schnittstellen zu der jeweiligen Einrichtung auf. Diese Schnittstellen können wahlweise analog oder digital sein. Die Bestandteile des Einbaugeräts 1 werden mit Bezugnahme auf die folgenden Figuren im Detail beschrieben.

In Fig. 2 sind die Einzelteile des Einbaugeräts 1 zu erkennen. An der Vorderseite ist die Einheit 3 zum Anzeigen und/oder Bedienen. Dahinter ist die Hauptplatine 4 angeordnet. Die Hauptplatine 4 ist an dem Zwischengehäuse 2 befestigt. Das Einbaugerät 1 weist auch zumindest ein Funktionsmodul 5, hier mehrere Funktionsmodule 5, auf. Die Funktionsmodule 5 sind im montierten Zustand in dem Zwischengehäuse 2 aufgenommen und mit der Hauptplatine 4 verbunden. Das Einbaugerät 1 weist auch eine Rückwand 6 auf, die das Zwischengehäuse 2 abdeckt. Das Einbaugerät 1 kann, wie in Fig. 2 dargestellt, mit einem Halterahmen 7 verbunden sein. Ferner besitzt das Einbaugerät 1 ein Schirmblech 8, das auch als Kabelabfang dient. Das Schirmblech 8 ist mit der Rückwand 6 verbunden. Das Schirmblech 8 übernimmt eine Abschirm- und/oder Erdungsfunktion.

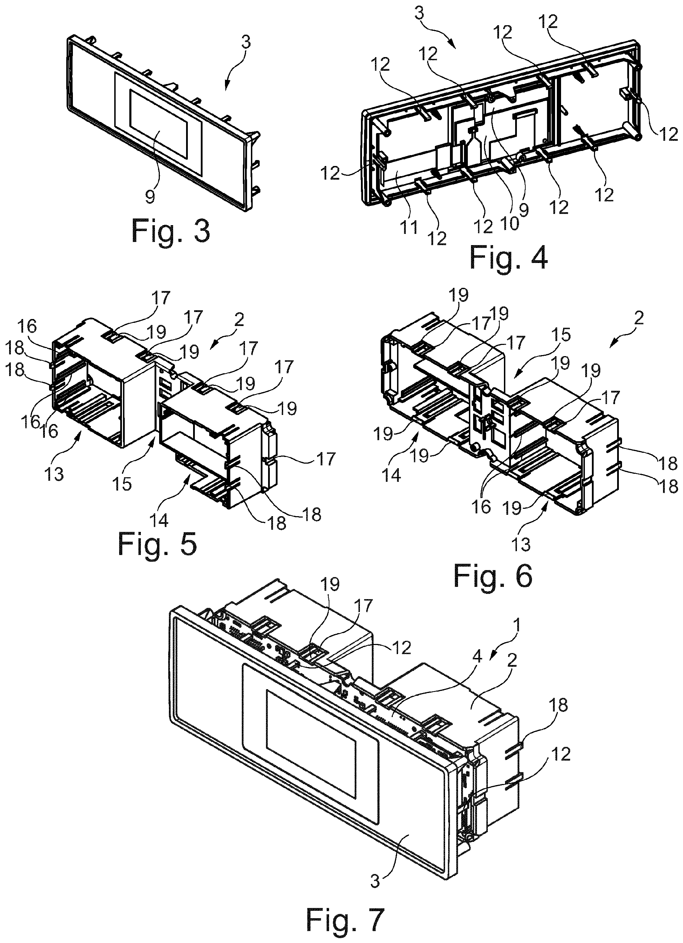

Fign. 3 und 4 zeigen die Einheit 3 zum Anzeigen und/oder Bedienen, die auch als eine Anzeige- und/oder Bedieneinheit oder als eine Displayeinheit bezeichnet wird. Die Einheit 3 weist einen Bildschirm 9 auf. Der Bildschirm 9 kann als ein Touchscreen oder als ein konventioneller Bildschirm ausgebildet sein. An einer Rückseite des Bildschirms 9 ist ein Adapterboard 10 angebracht. Die Einheit 3 ist mit der Hauptplatine 4 verbunden. Insbesondere kann das Adapterboard 10 über einen Flachbandkabelanschluss und ein daran anschließendes Flachbandkabel 11 mit der Hauptplatine 4 verbunden werden. Die Einheit 3 wird an dem Zwischengehäuse 2 formschlüssig befestigt. Dazu weist die Einheit 3 ein Bestandteil einer Clipsverbindung auf, die mit einem Gegenbestandteil der Clipsverbindung an dem Zwischengehäuse 2 zum Befestigen zusammenwirkt. Die Clipsverbindung ist zerstörungsfrei lösbar. Der Bestandteil der Clipsverbindung wird an der Einheit 3 durch mehrere Schnapphaken 12 gebildet.

Fign. 5 und 6 zeigen das Zwischengehäuse 2. Das Zwischengehäuse 2 ist in der dargestellten Ausführungsform als ein Tubusgehäuse ausgebildet. Das Zwischengehäuse 2 weist einen quaderförmigen ersten Innenraum 13 auf. Der Innenraum 13 dient zur Aufnahme eines oder mehrerer Funktionsmodule 5. Das Zwischengehäuse 2 weist einen quaderförmigen zweiten Innenraum 14 auf. Der Innenraum 14 dient zur Aufnahme eines oder mehrerer Funktionsmodule 5. Das Zwischengehäuse 2 weist einen quaderförmigen dritten Innenraum 15 auf. Der Innenraum 15 dient zur Aufnahme von Schnittstellen für die zu verbindenden Einrichtungen. In dem ersten und dem zweiten Innenraum 13, 14 sind Führungen 16 ausgebildet. Die Führungen 16 sind als Schienen ausgebildet. Die Führungen 16 dienen zur Aufnahme der Funktionsmodule 5. Jeweils zwei gegenüberliegende Führungen 16 dienen zur Aufnahme eines Funktionsmoduls 5. Mehrere Führungen 16 sind übereinander angeordnet, so dass die Funktionsmodule 5 gestapelt in den quaderförmigen Innenräumen 13, 14 aufgenommen werden können. Der erste und der zweite Innenraum 13, 14 sind von ihrer Erstreckung in Längsrichtung an die Größe der Funktionsmodule 5 angepasst. Der Gegenbestandteil der Clipsverbindung wird an dem Zwischengehäuse 2 durch mehrere, zu den Schnapphaken 12 korrespondierende Ausnehmungen 17 gebildet. Zudem weist das Zwischengehäuse 2 mehrere Schnapphaken 18 auf, die zum formschlüssigen Befestigen der Rückwand 6 dienen. Auch weist das Zwischengehäuse 2 mehrere Schnapphaken 19 zum formschlüssigen Aufnehmen der Hauptplatine 4 auf. An den Schnapphaken 19 sind die Ausnehmungen 17 ausgebildet.

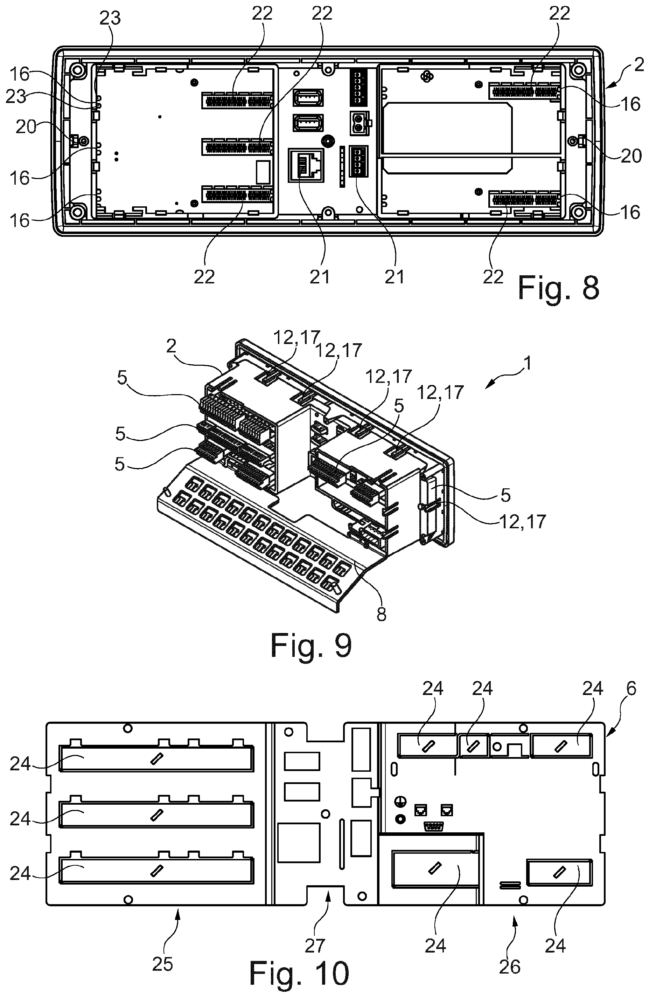

**In** Fig. 7 ist zu erkennen, dass die Hauptplatine 4 in das Zwischengehäuse 2 eingelegt ist und über eine Rast- oder Clipsverbindung der Schnapphaken 19 eingehakt ist. Die Einheit 3 wird frontseitig mit dem Zwischengehäuse 2 verrastet. Zudem kann die Einheit 3 über eine Schraubverbindung 20 (vgl. Fig. 8) an dem Zwischengehäuse 2 befestigt werden.

Fig. 8 zeigt eine rückseitige Ansicht des Einbaugeräts 1, in der der Aufbau der Hauptplatine 4 zu erkennen ist. Die Hauptplatine 4 weist zumindest eine Schnittstelle 21, hier mehrere Schnittstellen 21, auf. Die Schnittstellen 21 sind in einem in Breitenrichtung zentralen Abschnitt der Hauptplatine 4 angeordnet. Die Schnittstellen 21 können als analoge und/oder digitale Schnittstellen ausgebildet sein. Die Schnittstellen 21 dienen zum Anschluss der Einrichtungen. Beispielsweise kann über eine der Schnittstellen 21 ein USB-WLAN-Stick, ein USB-Ethernet-Stick, ein USB-Funkmodul, ein USB-Bluetooth-Stick oder der gleichen angeschlossen werden.

Die Hauptplatine 4 weist zumindest eine Aufnahmeschnittstelle 22, hier mehrere Aufnahmeschnittstellen 22, auf. Die Aufnahmeschnittstellen 22 dienen zur Aufnahme jeweils eines Funktionsmoduls 5. Das Funktionsmodul 5 ist beispielsweise über eine Steckverbindung mit der Aufnahmeschnittstelle 22 verbunden. Das Funktionsmodul 5 ist beispielsweise als eine Optionskarte oder eine Speicherkarte oder dergleichen ausgebildet, die in eine der auch als Slot bezeichneten Aufnahmeschnittstellen 22 eingesetzt ist. Zu beiden Seiten in Breitenrichtung der Aufnahmeschnittstellen 22 ist eine der Führungen 16 angeordnet. Jede Führung 16 wird, etwa wie eine Schiene, durch zwei in Höhenrichtung zueinander versetzte Vorsprünge 23 gebildet, zwischen denen das Funktionsmodul 5 eingeschoben werden kann. Somit wird das Funktionsmodul 5 insbesondere beim Einschieben geführt und nach der Montage stabil gehalten. In der dargestellten Ausführungsform sind mehrere Funktionsmodule 5 übereinandergestapelt angeordnet.

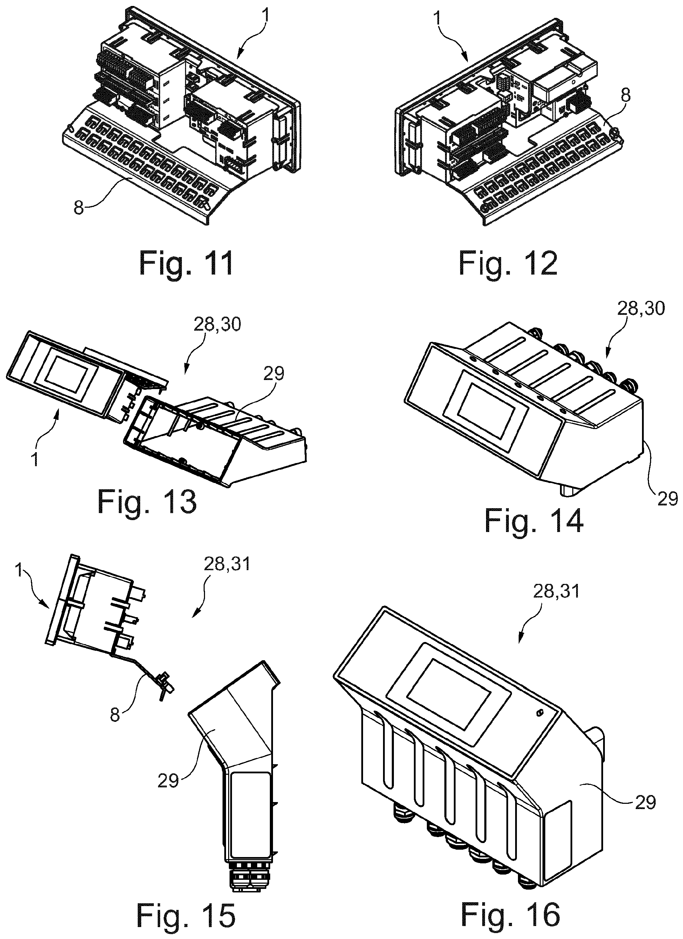

Fig. 9 zeigt das Einbaugerät 1 mit dem montierten Schirmblech 8. Das Schirmblech 8 ist formschlüssig, hier über eine Clipsverbindung, an dem Zwischengehäuse 2 angebracht. Das Schirmblech 8 kann an einer Unterseite des Zwischengehäuses 2 (vgl. Fig. 9) oder an einer Oberseite des Zwischengehäuses 2 (vgl. Fig. 13) angebracht sein. Das Schirmblech 8 weist zumindest zwei zueinander geneigte Abschnitte auf. Dabei erstreckt sich im montierten Zustand der eine Abschnitt parallel zu einer Unterseite bzw. einer Oberseite des Zwischengehäuses 2 und der andere Abschnitt neigt sich nach außen, d.h. weg von dem Einbaugerät. Je nach Einbauart wird das Schirmblech 8 in einer der beiden Positionen befestigt.

Fig. 10 zeigt die Rückwand 6. Die Rückwand 6 weist mehrere Abdeckbleche 24 auf, die je nach Bedarf herausgetrennt werden können. Die Abdeckbleche 24 sind unterschiedlich groß und an die jeweilige abzudeckende Schnittstelle 21 oder Schnittstelle 22 angepasst. In einem ersten Abschnitt 25 der Rückwand 6, der den ersten Innenraum 13 des Zwischengehäuses 2 abdeckt, sind drei Abdeckbleche 24 zur Abdeckung von Aufnahmeschnittstellen 22 für die Funktionsmodule 5 ausgebildet. In einem zweiten Abschnitt 26 der Rückwand 6, der den zweiten Innenraum 14 des Zwischengehäuses 2 abdeckt, sind mehrere Abdeckbleche 24 unterschiedlicher Größe für die Aufnahmeschnittstellen 22 angeordnet. In einem dritten Abschnitt 27 der Rückwand 6, der den (mittleren) dritten Innenraum 15 des Zwischengehäuses 2 abdeckt, sind mehrere Abdeckbleche 24 unterschiedlicher Größe für die Schnittstellen 21 ausgebildet. Die Rückwand 6 ist an die Außenform des Zwischengehäuses 2 angepasst und liegt an dieser an (vgl. Fign. 11 und 12). Demnach ist der mittlere dritte Abschnitt 27 der Rückwand in Längsrichtung zu dem ersten Abschnitt 25 und dem zweiten Abschnitt 26 versetzt ausgebildet. Die Rückwand 6 dient zur Abschirmung und Erdung der in dem Zwischengehäuse 2 aufgenommen Bauteile. Insbesondere dient die Rückwand 6 als Massenanschluss aller modularen Funktionsmodule 5.

Fign. 13 bis 15 zeigen eine erfindungsgemäße (Daten-)Verarbeitungsvorrichtung 28. Die Verarbeitungsvorrichtung 28 dient zum Steuern, Messen und/oder Regeln. Die Verarbeitungsvorrichtung 28 wird auch als Controller oder Steuer-, Mess- und/oder Regelgerät bezeichnet. Die Verarbeitungsvorrichtung 28 weist das Einbaugerät 1 und ein Außengehäuse 29 auf. Das Einbaugerät 1 ist in dem Außengehäuse 29 aufgenommen. Insbesondere ist das Einbaugerät 1 kraftschlüssig in dem Außengehäuse 29 befestigt. Alternativ zu dem Außengehäuse 29 kann das Einbaugerät 1 mit dem Halterahmen 7 (vgl. Fig. 2) angebracht werden. Dann kann das Einbaugerät 1 beispielsweise direkt in einem Schaltschrank oder eine sonstige Konsole untergebracht werden.

Die Verarbeitungsvorrichtung 28 kann als ein Tischgerät 30 (vgl. Fign. 13 und 14) oder als ein Wandgerät 31 (vgl. Fign. 15 und 16) ausgebildet sein. Das Einbaugerät 1 kann in dem Außengehäuse 29 wahlweise in einer ersten Position und in einer zu der ersten Position um eine Achse senkrecht zur Bildschirmfläche der Einheit 3 um 180° gedrehten, zweiten Position eingesetzt werden. Dadurch kann dasselbe Außengehäuse 29 für zwei unterschiedlichen Anwendungen bzw. unterschiedliche Positionen zum Einsatz kommen. In der ersten Position wird das Tischgerät 30 ausgebildet, in der es für einen Benutzer auf einem Tisch etc. stehend bedient werden kann. In der zweiten Position wird das Wandgerät 31 ausgebildet, in der es für einen Benutzer an einer Wand etc. befestigt bedient werden kann.

Die Verarbeitungsvorrichtung 28 ist mehrteilig ausgebildet. Die Einzelbauteile der Verarbeitungsvorrichtung 28 können vorzugsweise voneinander zerstörungsfrei gelöst werden. Die Einzelbauteile sind vorzugsweise formschlüssig aneinander oder dem Außengehäuse 29 befestigt. Weiterhin kann das Außengehäuse mehrteilig, vorzugsweise zweiteilig vorgesehen sein. Die Einzelteile des Außengehäuses, etwa ein Ober- und ein Unterteil, können zusätzlich über nicht dargestellte Sicherungsseile, etwa Nylonseile, miteinander verbunden sein. Bei einer Wartung, beim Ein - oder Ausbau eines Funktionsmoduls 5 oder sonstigen Arbeiten an der Verarbeitungsvorrichtung 28 im industriellen Umfeld sind die empfindlichen elektronischen Bauteile dadurch gesichert. Das Oberteil des Außengehäuses 29 mit darin montiertem Einbaugerät 1 braucht demensprechend bei staubiger und schmutziger Umgebung nicht abgelegt und zusätzlich geschützt zu werden.

### Bezugszeichenliste

- 1: Einbaugerät / Ausgabe- und/oder Eingabegerät
- 2: Zwischengehäuse
- 3: Einheit / Anzeige- und/oder Bedieneinheit
- 4: Hauptplatine
- 5: Funktionsmodul
- 6: Rückwand
- 7: Halterahmen
- 8: Schirmblech
- 9: Bildschirm
- 10: Adapterboard
- 11: Flachbandkabel
- 12: Schnapphaken
- 13: erster Innenraum
- 14: zweiter Innenraum
- 15: dritter Innenraum
- 16: Führung
- 17: Ausnehmung
- 18: Schnapphaken
- 19: Schnapphaken
- 20: Schraubverbindung
- 21: Schnittstelle
- 22: Aufnahmeschnittstelle
- 23: Vorsprung
- 24: Abdeckblech
- 25: erster Abschnitt
- 26: zweiter Abschnitt
- 27: dritter Abschnitt
- 28: Verarbeitungsvorrichtung
- 29: Außengehäuse
- 30: Tischgerät
- 31: Wandgerät

## Patentansprüche

1. Verarbeitungsvorrichtung zum Steuern, Messen und/oder Regeln, mit einem Einbaugerät (1) zur Ausgabe und/oder Eingabe, mit einem Zwischengehäuse (2), einer Einheit (3) zum Anzeigen und/oder Bedienen, und einer mit der Einheit (3) verbundene Hauptplatine (4), wobei die Hauptplatine (4) eine zentrale Recheneinheit aufweist, **dadurch gekennzeichnet, dass** das Einbaugerät (1) zur Verwendung in einer oder für eine signalgebende oder signalverarbeitende Einrichtung wahlweise einer Wägeeinrichtung, Dosiereinrichtung, Fördereinrichtung, Siebeinrichtung, Mahleinrichtung, Mischeinrichtung, Filtereinrichtung, Zustandsüberwachungseinrichtung und/oder Materialanalyseeinrichtung vorgesehen ist, wobei die Hauptplatine (4) als eine elektronische Plattform unabhängig von der Verwendung dient und je Verwendung eine spezifische Kombination von Schnittstellen (21) zu der jeweiligen Einrichtung aufweist,
wobei die Hauptplatine (4) des Einbaugeräts (1) für alle Einrichtungen gleich ist,
wobei das Einbaugerät (1) modular für die mehreren und/oder die verschiedenen Verwendungen einsetzbar ist,
**dadurch gekennzeichnet, dass**
das Einbaugerät (1) modular mit einem oder mehreren Funktionsmodulen (5) ausgewählt aus einer Vielzahl von Funktionsmodulen (5) ausgestattet ist,
wobei durch ein Verbinden des oder der Funktionsmodule (5) mit der Hauptplatine unterschiedliche Funktionen realisiert werden,
wobei die spezifische Kombination von Schnittstellen wenigstens eine analoge Schnittstelle und/oder wenigstens eine digitale Schnittstelle zur Datenübertragung zu der jeweiligen Einrichtung aufweist,
wobei die Hauptplatine (4) eine oder mehrerer Aufnahmeschnittstellen (22) zur Aufnahme und Verbindung jeweils eines der ein oder mehreren Funktionsmodule (5) aufweist.

2. Verarbeitungsvorrichtung nach Anspruch 1, **dadurch gekennzeichnet, dass** die Einheit (3) zum Anzeigen und/oder Bedienen formschlüssig mit dem Zwischengehäuse (2) zerstörungsfrei verbindbar und zerstörungsfrei lösbar ist.

3. Verarbeitungsvorrichtung nach Anspruch 1 oder 2, **dadurch gekennzeichnet, dass** das Funktionsmodul (5) wiederum eine spezifische Schnittstelle zur jeweiligen Einrichtung umfasst.

4. Verarbeitungsvorrichtung nach einem der vorhergehenden Ansprüche, **dadurch gekennzeichnet, dass** das Funktionsmodul (5) oder die Funktionsmodule, vorzugsweise über eine Steckverbindung, mit der Aufnahmeschnittstelle (22) zerstörungsfrei verbindbar und von der Aufnahmeschnittstelle (22) zerstörungsfrei lösbar sind.

5. Verarbeitungsvorrichtung nach einem der vorhergehenden Ansprüche, **dadurch gekennzeichnet, dass** das Zwischengehäuse (2) Führungen (16) besitzt, in denen die Funktionsmodule (5) führbar sind.

6. Verarbeitungsvorrichtung nach einem der vorhergehenden Ansprüche, **dadurch gekennzeichnet, dass** das Einbaugerät (1) eine Rückwand (6) aufweist, die vorzugsweise formschlüssig, mit dem Zwischengehäuse (2) zerstörungsfrei verbindbar und von dem Zwischengehäuse (2) zerstörungsfrei lösbar ist.

7. Verarbeitungsvorrichtung nach Anspruch 6, **dadurch gekennzeichnet, dass** die Rückwand (6) heraustrennbare Abdeckbleche (24) besitzt, die jeweils eine Schnittstelle (21) oder Aufnahmeschnittstelle (22) der Hauptplatine (4) abdecken.

8. Verarbeitungsvorrichtung nach einem der vorhergehenden Ansprüche, **dadurch gekennzeichnet, dass** das Einbaugerät (1) und/oder die Einheit (3) um eine Achse senkrecht zur Bildschirmfläche der Einheit (3), vorzugsweise um 180° oder 90°, drehbar ausgebildet sind.

9. Verarbeitungsvorrichtung nach einem der vorhergehenden Ansprüche, **dadurch gekennzeichnet, dass** das Einbaugerät (1) mit einem Außengehäuse (29) der Verarbeitungsvorrichtung und/oder einem Halterahmen (7) der Verarbeitungsvorrichtung, vorzugsweise kraftschlüssig, verbindbar ist.

10. Verarbeitungsvorrichtung nach Anspruch 9, **dadurch gekennzeichnet, dass** das Außengehäuse (29) mehrteilig ausgebildet ist, wobei die Bauteile des Außengehäuses (29), vorzugsweise formschlüssig und voneinander lösbar, miteinander verbindbar sind.

11. Verarbeitungsvorrichtung nach einem der Ansprüche 9 oder 10, **dadurch gekennzeichnet, dass** das Einbaugerät (1) in dem Außengehäuse (29) wahlweise in einer ersten Position und in einer zu der ersten Position um eine Achse senkrecht zur Bildschirmfläche der Einheit (3) um 180° gedrehten, zweiten Position befestigbar ist.

12. Verarbeitungsvorrichtung nach einem der Ansprüche 9 bis 11, **dadurch gekennzeichnet, dass** das Außengehäuse (29), in dem das Einbaugerät (1) aufgenommen ist, vorzugsweise an einer Wand befestigbar oder auf einen Tisch stellbar ist.

13. Verarbeitungsvorrichtung nach einem Ansprüche 9 bis 12, **dadurch gekennzeichnet, dass** Sicherungsseile, vorzugsweise Nylonseile, zur Befestigung voneinander lösbarer Bauteile des Außengehäuses (29) vorgesehen sind.

14. Verarbeitungsvorrichtung nach einem der vorhergehenden Ansprüche, **dadurch gekennzeichnet, dass** das Zwischengehäuse (2) in Form eines Tubusgehäuses ausgebildet ist, das wenigstens einen quaderförmigen Innenraum (13, 14, 15) zum Aufnehmen des wenigstens einen Funktionsmoduls (5) oder mehrerer Funktionsmodule (5) und/oder der Schnittstellen (21) aufweist.

15. Verarbeitungsvorrichtung nach Anspruch 14, **dadurch gekennzeichnet, dass** eine Rückwand (6) des Einbaugeräts (1) der Form des Zwischengehäuses (2), insbesondere des als Tubusgehäuse ausgebildeten Zwischengehäuses (2), angepasst ist und dementsprechend als Masse -Anschluss aller modularen Funktionsmodule (5) dient.

## Claims

1. Processing apparatus for controlling, measuring, and/or regulating, with an appliance for installation (1) for output and/or input, with an intermediate housing (2), a unit (3) for display and/or operation, and a main board (4) connected to the unit (3), wherein the main board (4) has a central processing unit, **characterized in that** the appliance for installation (1) is intended for use in or for a signaling or signal-processing device, optionally a weighing device, metering device, conveying device, screening device, grinding device, mixing device, filter device, status monitoring device and/or material analysis device, wherein the main board (4) serves as an electronic platform regardless of use and has, for each use, a particular combination of interfaces (21) to the device in question,
wherein the main board (4) of the appliance for installation (1) is the same for all devices,
wherein the appliance for installation (1) can be used modularly for the several and/or the different uses,
**characterized in that**
the appliance for installation (1) is modularly equipped with one or more function modules (5) selected from a plurality of function modules (5),
wherein different functions are realized by connecting the function module(s) (5) to the main board,
wherein the specific combination of interfaces comprises at least one analog interface and/or at least one digital interface for data transmission to the respective device,
wherein the main board (4) contains one or more receiving interfaces (22), for receipt and connection of each of the one or more function modules (5).

2. Processing apparatus according to claim 1, **characterized in that** the unit (3) for display and/or operation is form-fittingly, non-destructively connectable to the intermediate housing (2) and non-destructively detachable.

3. Processing apparatus according to claim 1 or 2, **characterized in that** the function module (5) in turn includes a specific interface to the respective device.

4. Processing apparatus according to any one of the preceding claims,
**characterized in that** the function module (5) or function modules can be connected non-destructively to the receiving interface (22), preferably via a plug-in connection, and can be detached from the receiving interface (22) non-destructively.

5. Processing apparatus according to any one of the preceding claims,
**characterized in that** the intermediate housing (2) has guides (16) in which the function modules (5) can be guided.

6. Processing apparatus according to any one of the preceding claims,
**characterized in that** the appliance for installation (1) has a back wall (6), which is preferably form-fitting, can be connected to the intermediate housing (2) non-destructively and can be detached from the intermediate housing (2) non-destructively.

7. Processing apparatus according to claim 6, **characterized in that** the back wall (6) has detachable cover plates (24), each of which covers an interface (21) or receiving interface (22) of the main board (4).

8. Processing apparatus according to any one of the preceding claims, **characterized in that** the appliance for installation (1) and/or the unit (3) are designed to rotate about an axis perpendicular to the screen surface of the unit (3), preferably by 180° or 90°.

9. Processing apparatus according to any one of the preceding claims, **characterized in that** the appliance for installation (1) can be connected to an outer housing (29) of the processing apparatus and/or a holding frame (7) of the processing apparatus, preferably in a force-fit.

10. Processing apparatus according to claim 9, **characterized in that** the outer housing (29) is designed in several parts, wherein the components of the outer housing (29) can be connected to each other, preferably in a form-fitting manner and detachable from each other.

11. Processing apparatus according to any one of claims 9 or 10, **characterized in that** the appliance for installation (1) can be attached in the outer housing (29) either in a first position or in a second position rotated by 180° to the first position about an axis perpendicular to the display surface of the unit (3).

12. Processing apparatus according to any one of claims 9 to 11, **characterized in that** the outer housing (29) in which the appliance for installation (1) is accommodated, can preferably be attached to a wall, or placed on a table.

13. Processing apparatus according to any one of claims 9 to 12, **characterized in that** safety ropes, preferably nylon ropes, are provided for fastening components of the outer housing (29) that are detachable from one another.

14. Processing apparatus according to any one of the preceding claims, **characterized in that** the intermediate housing (2) is designed in the shape of a tube housing which has at least one cuboid inner space (13, 14, 15) for accommodating the at least one function module (5) or several function modules (5) and/or the interfaces (21).

15. Processing apparatus according to claim 14, **characterized in that** a back wall (6) of the appliance for installation (1) is adapted to the shape of the intermediate housing (2), in particular the intermediate housing (2) designed as a tube housing, and accordingly serves as a ground connection for all modular function modules (5).

## Revendications

1. Dispositif de traitement pour la commande, la mesure et/ou la régulation, comprenant
un appareil encastrable (1) pour la sortie et/ou l'entrée, un boîtier intermédiaire (2), une unité (3) d'affichage et/ou de commande, et une carte mère (4) reliée à l'unité (3), la carte mère (4) comportant une unité centrale de traitement, **caractérisé en ce que** l'appareil encastrable (1) est prévu pour être utilisé dans ou pour un dispositif de signalisation ou de traitement de signaux à savoir, au choix, un dispositif de pesage, un dispositif de dosage, un dispositif de transport, un dispositif de tamisage, un dispositif de broyage, un dispositif de mélange, un dispositif de filtrage, un dispositif de surveillance d'état et/ou un dispositif d'analyse de matériaux, la carte mère (4) servant de plateforme électronique indépendante de l'utilisation et présentant une combinaison spécifique d'interfaces (21) avec le dispositif respectif pour chaque utilisation,
la carte mère (4) de l'appareil encastrable (1) étant la même pour tous les dispositifs,
l'appareil encastrable (1) pouvant être utilisé de manière modulaire pour les multiples et/ou différentes utilisations,
**caractérisé en ce que** l'appareil encastrable (1) est équipé de manière modulaire d'un ou plusieurs modules fonctionnels (5) choisis parmi une multitude de modules fonctionnels (5),
différentes fonctions étant prises en charge par la connexion du ou des modules fonctionnels (5) à la carte mère,
la combinaison spécifique d'interfaces comprenant au moins une interface analogique et/ou
au moins une interface numérique pour la transmission de données vers le dispositif concerné,
la carte mère (4) comprenant une ou plusieurs interfaces de réception (22) pour recevoir et connecter respectivement l'un des modules fonctionnels (5), qui peuvent être au nombre de un ou davantage.

2. Dispositif de traitement selon la revendication 1, **caractérisé en ce que**
l'unité (3) d'affichage et/ou de commande peut être reliée sans dégradation au boîtier intermédiaire (2) par complémentarité de formes et détachée sans dégradation de ce boîtier.

3. Dispositif de traitement selon la revendication 1 ou 2, **caractérisé en**
**ce que** le module fonctionnel (5) comprend, de son côté, une interface spécifique pour le dispositif respectif.

4. Dispositif de traitement selon l'une des revendications précédentes,
**caractérisé en ce que** le module fonctionnel (5) ou les modules fonctionnels peuvent être connectés sans dégradation à l'interface de réception (22), de préférence par l'intermédiaire d'un connecteur, et détachés sans dégradation de l'interface de réception (22).

5. Dispositif de traitement selon l'une des revendications précédentes,
**caractérisé en ce que** le boîtier intermédiaire (2) possède des guides (16) dans lesquels les modules fonctionnels (5) peuvent être guidés.

6. Dispositif de traitement selon l'une des revendications précédentes,
**caractérisé en ce que** l'appareil encastrable (1) présente une paroi arrière (6) qui peut être reliée de préférence par complémentarité de forme, sans dégradation, au boîtier intermédiaire (2) et détachée sans dégradation du boîtier intermédiaire (2).

7. Dispositif de traitement selon la revendication 6, **caractérisé en ce que** la
paroi arrière (6) possède une plaque de recouvrement (24) amovible qui recouvre soit une interface (21), soit une interface de réception (22) de la carte mère (4).

8. Dispositif de traitement selon l'une des revendications précédentes, **caractérisé en ce que** l'appareil encastrable (1) et/ou l'unité (3) sont conçus de manière à pouvoir tourner autour d'un axe perpendiculaire à la surface de l'écran de l'unité (3), de préférence de 180° ou 90°.

9. Dispositif de traitement selon l'une des revendications précédentes, **caractérisé en ce que** l'appareil encastrable (1) peut être relié, de préférence par adhérence, à un boîtier extérieur (29) du dispositif de traitement et/ou à un cadre de support (7) du dispositif de traitement.

10. Dispositif de traitement selon la revendication 9, **caractérisé en ce que** le boîtier extérieur (29) est constitué de plusieurs parties, les composants du boîtier extérieur (29) pouvant être reliés entre eux, de préférence par complémentarité de forme et de manière amovible.

11. Dispositif de traitement selon l'une des revendications 9 ou 10, **caractérisé en ce que** l'appareil encastrable (1) peut être fixé dans le boîtier extérieur (29), au choix dans une première position ou dans une deuxième position tournée de 180° par rapport à la première position autour d'un axe perpendiculaire à la surface de l'écran de l'unité (3).

12. Dispositif de traitement selon l'une des revendications 9 à 11, **caractérisé en ce que** le boîtier extérieur (29), dans lequel est logé l'appareil encastrable (1), peut au choix être fixé à un mur ou posé sur une table.

13. Dispositif de traitement selon l'une des revendications 9 à 12, **caractérisé en ce que** des câbles de sécurité, de préférence des câbles en nylon, sont prévus pour fixer les composants amovibles les uns des autres du boîtier extérieur (29).

14. Dispositif de traitement selon l'une des revendications précédentes, **caractérisé en ce que** le boîtier intermédiaire (2) se présente sous la forme d'un boîtier tubulaire, qui présente au moins un espace intérieur parallélépipédique (13, 14, 15) destiné à recevoir le module fonctionnel (5) ou les modules fonctionnels (5) et/ou les interfaces (21).

15. Dispositif de traitement selon la revendication 14, **caractérisé en ce qu'**une paroi arrière (6) de l'appareil encastrable (1) est adaptée à la forme du boîtier intermédiaire (2), en particulier du boîtier intermédiaire (2) conçu comme un boîtier tubulaire, et sert en conséquence de raccordement à la masse de tous les modules fonctionnels modulaires (5).
